(19) Europäisches Patentamt
European Patent Office
Office européen des brevets

(11) EP 2 821 421 A1

(12) # EUROPEAN PATENT APPLICATION
published in accordance with Art. 153(4) EPC

(43) Date of publication:
**07.01.2015 Bulletin 2015/02**

(21) Application number: **13754064.7**

(22) Date of filing: **25.02.2013**

(51) Int Cl.:
***C08G 10/04** (2006.01)* ***G03F 7/11** (2006.01)*

(86) International application number:
**PCT/JP2013/054763**

(87) International publication number:
**WO 2013/129313 (06.09.2013 Gazette 2013/36)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **27.02.2012 JP 2012039501**

(71) Applicant: **Mitsubishi Gas Chemical Company, Inc.**
**Tokyo 100-8324 (JP)**

(72) Inventors:
- **UCHIYAMA, Naoya**
  **Hiratsuka-shi**
  **Kanagawa 254-0016 (JP)**
- **HIGASHIHARA, Go**
  **Kurashiki-shi**
  **Okayama 712-8525 (JP)**
- **ECHIGO, Masatoshi**
  **Hiratsuka-shi**
  **Kanagawa 254-0016 (JP)**

(74) Representative: **Hoffmann Eitle**
**Patent- und Rechtsanwälte PartmbB**
**Arabellastraße 30**
**81925 München (DE)**

(54) **ACIDIFIED MONO ALKYL NAPHTHALENE FORMALDEHYDE RESIN**

(57) Provided are a novel resin and a precursor thereof that are excellent in thermal decomposability and solubility in a solvent. The resin is obtained by subjecting, to an acidic treatment, a monoalkylnaphthalene formaldehyde resin that is obtained by reacting a compound represented by the following formula (1), wherein $R_1$ represents an alkyl group having 1 to 4 carbon atoms, and formaldehyde in the presence of a catalyst.

EP 2 821 421 A1

## Description

Technical field

The present invention relates to a novel resin, and in particular, relates to an acidic treatment-subjected monoalkylnaphthalene formaldehyde resin.

Background Art

A characteristic of being hardly thermally decomposed (thermal decomposability) and a good solubility in a solvent in order to be easily handled are required of resins for use as, for example, electrically insulating materials, resist resins, semiconductor sealing resins, adhesives for printed wiring boards; matrix resins for electrical laminated plates mounted on electric equipment, electronic equipment, industrial equipment and the like; matrix resins for prepregs mounted on electric equipment, electronic equipment, industrial equipment and the like; materials for build-up laminated plates, resins for fiber-reinforced plastics, sealing resins for liquid crystal display panels, paints, various coating agents, adhesives, coating agents for semiconductors, or resist resins for semiconductor manufacturing. As resins having such characteristics, an aromatic hydrocarbon resin obtained by reacting a polycyclic aromatic hydrocarbon including a monoalkylnaphthalene or a dialkylnaphthalene as a main component and paraformaldehyde in the presence of an aromatic monosulfonic acid (see Patent Literature 1), a phenol resin having a structure obtained by reacting a methoxymethylnaphthalene compound and a compound having a phenolic hydroxyl group, such as phenol, cresol or naphthol, in the presence of diethyl sulfate to bind the naphthalene to the compound having a phenolic hydroxyl group via a methylene group (see Patent Literature 2), and the like are known.

In addition, a technique for improving thermal decomposability in which the above-described aromatic hydrocarbon resin obtained by using a dialkylnaphthalene is reacted with an acid and a compound having a phenolic hydroxyl group to provide a modified resin is known (see Patent Literatures 3 and 4).

It is known that thermal decomposition can be suppressed when the carbon concentration in a resin is higher. As such a resin, for example, an acenaphthene resin having a unit structure represented by the following formula is known (see Patent Literature 5).

[Formula 1]

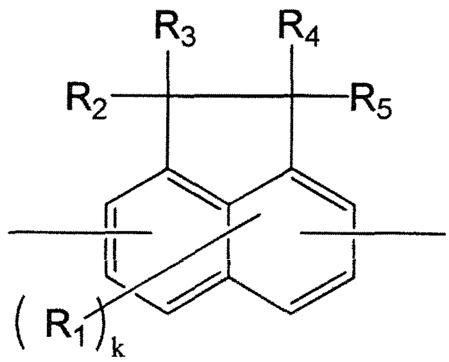

wherein $R_1$ represents a monovalent atom or group and k represents an integer of 0 to 4, provided that k represents 2 to 4, a plurality of $R_1$ may be the same or different; and $R_2$ to $R_5$ independently represent a hydroxy group, or a monovalent atom or group.

Citation List

Patent Literatures

Patent Literature 1: Japanese Patent Laid-Open No. 54-86593
Patent Literature 2: Japanese Patent Laid-Open No. 2004-91550
Patent Literature 3: Japanese Patent Laid-Open No. 2009-155638
Patent Literature 4: Japanese Patent Laid-Open No. 2011-46837

Patent Literature 5: Japanese Patent Laid-Open No. 2000-143937

Summary of Invention

Technical Problem

However, the resins described in Patent Literatures 1 and 2 as well as the modified resins described in Patent Literatures 3 and 4 have still insufficient thermal decomposability. In addition, the acenaphthene resin having the specified structure described in Patent Literature 5 has a disadvantage of having a too high carbon concentration, resulting in a low solubility in a solvent.

The present invention has been made in view of the above problems, and an object thereof is to provide a novel resin and a precursor thereof that are excellent in thermal decomposability and solubility in a solvent. In addition, another object of the present invention is to provide a novel resin that can be suitably used as a resin for electronic materials.

Solution to Problem

The present inventors have made intensive studies in order to solve the above problems, and as a result, have found that a resin obtained by subjecting, to an acidic treatment, a monoalkylnaphthalene formaldehyde resin that is obtained by reacting a compound represented by the following formula (1) and formaldehyde in the presence of a catalyst can solve the above problems, thereby leading to the present invention.

That is, the present invention provides the following [1] to [17].

[1] A resin obtained by subjecting a monoalkylnaphthalene formaldehyde resin to an acidic treatment, wherein the monoalkylnaphthalene formaldehyde resin is obtained by reacting a compound represented by the following formula (1) and formaldehyde in the presence of a catalyst:

[Formula 2]

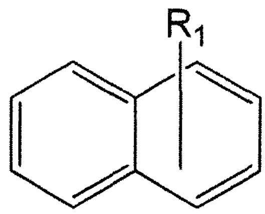

(1)

wherein $R_1$ represents an alkyl group having 1 to 4 carbon atoms.

[2] The resin according to above [1], wherein the acidic treatment is a treatment using an acidic catalyst and a compound represented by the following formula (2):

[Formula 3]

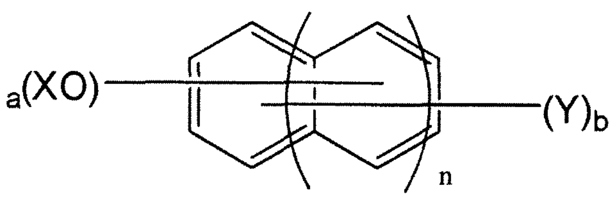

(2)

wherein a represents an integer of 1 to 3, each X independently represents a hydrogen atom, an alkyl group having 1 to 10 carbon atoms, an aryl group having 6 to 10 carbon atoms or a cyclohexyl group, b represents an integer of 0 to 3, each Y independently represents an alkyl group having 1 to 10 carbon atoms, an aryl group having 6 to 10 carbon atoms or a cyclohexyl group, and n represents an integer of 0 to 2.

[3] The modified monoalkylnaphthalene formaldehyde resin according to above [2], wherein the compound represented by the formula (2) is at least one selected from the group consisting of phenylphenol, naphthol, methoxynaphthol, benzoxynaphthol, dihydroxynaphthalene, hydroxyanthracene, methoxyanthracene, benzoxyanthracene and dihydroxyanthracene.
[4] The resin according to above [2] or [3], wherein an amount of the compound represented by the formula (2) used is 0.1 to 5 mol based on 1 mol of oxygen contained in the monoalkylnaphthalene formaldehyde resin.
[5] The resin according to above [1], wherein the acidic treatment is a treatment using an acidic catalyst and water.
[6] The resin according to above [5], wherein an amount of the acidic catalyst used is 0.0001 to 100 parts by mass based on 100 parts by mass of the monoalkylnaphthalene formaldehyde resin.
[7] A resin obtained by subjecting the resin according to above [5] or [6] to an acidic treatment using the acidic catalyst and the compound represented by the above formula (2).
[8] The resin according to above [7], wherein the compound represented by the formula (2) is at least one selected from the group consisting of phenylphenol, naphthol, methoxynaphthol, benzoxynaphthol, dihydroxynaphthalene, hydroxyanthracene, methoxyanthracene, benzoxyanthracene and dihydroxyanthracene.
[9] The resin according to [7] or [8], wherein an amount of the compound represented by the formula (2) used is 0.1 to 5 mol based on 1 mol of oxygen contained in the monoalkylnaphthalene formaldehyde resin.
[10] An underlayer film resin obtained by subjecting a monoalkylnaphthalene formaldehyde resin to an acidic treatment, wherein the monoalkylnaphthalene formaldehyde resin is obtained by reacting the compound represented by the above formula (1) and formaldehyde in the presence of a catalyst.
[11] The underlayer film resin according to above [10], wherein the acidic treatment is performed by using an acidic catalyst and the compound represented by the above formula (2), and/or performed using an acidic catalyst and water.
[12] A material for forming an underlayer film comprising at least the resin according to above [1] and an organic solvent.
[13] The material for forming the underlayer film according to above [12], further comprising an acid generator.
[14] The material for forming the underlayer film according to above [12] or [13], further comprising a crosslinking agent.
[15] An underlayer film for lithography, formed of the material for forming the underlayer film according to any one of above [12] to [14].
[16] A pattern forming method comprising forming an underlayer film on a substrate using the material for forming the underlayer film according to any one of above [12] to [14], forming at least one photoresist layer on the underlayer film, then irradiating a required region of the photoresist layer with radiation, and performing alkaline development.
[17] A pattern forming method comprising forming an underlayer film on a substrate by using the material for forming the underlayer film according to any one of above [12] to [14], forming an intermediate layer film on the underlayer film by using a silicon atom-containing resist intermediate layer film material, forming at least one photoresist layer on the intermediate layer film, then irradiating a required region of the photoresist layer with radiation, performing alkaline development to form a resist pattern, thereafter etching the intermediate layer film while the resist pattern serves as a mask, etching the underlayer film while the resulting intermediate layer film pattern serves as an etching mask, and etching the substrate while the resulting underlayer film pattern serves as an etching mask to thereby form a pattern on the substrate.

Advantageous Effects of Invention

According to the present invention, a novel resin and a precursor thereof that are excellent in thermal decomposability and solubility in a solvent are realized. Accordingly, this resin is useful as a thermosetting resin used in fields in which these characteristics are required (for example, electrically insulating materials, resist resins, semiconductor sealing resins, adhesives for printed wiring boards; matrix resins for electric laminated plates and prepregs mounted on electric equipment, electronic equipment, industrial equipment and the like; materials for build-up laminated plates, resins for fiber-reinforced plastics, sealing resins for liquid crystal display panels, paints, various coating agent, adhesives, laminated plates for electronic parts, molded products, film materials, and sealing materials).

Description of Embodiments

Hereinafter, an embodiment of the present invention will be described. It is to be noted that the following embodiment is illustrative for describing the present invention and the present invention is not limited only to the embodiment.

[Acidic treatment-subjected monoalkylnaphthalene formaldehyde resin]

A resin of the present embodiment is obtained by subjecting, to an acidic treatment, a monoalkylnaphthalene formaldehyde resin that is obtained by reacting a compound represented by the following formula (1) and formaldehyde in the presence of a catalyst:

[Formula 4]

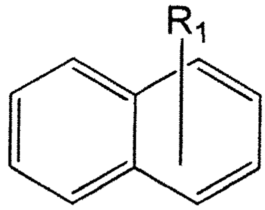

(1)

wherein $R_1$ represents an alkyl group having 1 to 4 carbon atoms.

<Monoalkylnaphthalene formaldehyde resin>

The monoalkylnaphthalene formaldehyde resin used herein is not particularly restricted as long as the resin is obtained by a condensation reaction of the monoalkylnaphthalene compound represented by the above formula (1) and formaldehyde in the presence of a catalyst.

The synthesis method of the monoalkylnaphthalene formaldehyde resin is not particularly limited, and a known method can be applied thereto. For example, based on the method described in Japanese Patent No. 37-5747, the monoalkylnaphthalene formaldehyde resin can be obtained by a condensation reaction of the monoalkylnaphthalene compound represented by the above formula (1) and formaldehyde in the presence of a catalyst. The monoalkylnaphthalene formaldehyde resin obtained by the above method can be identified by gel permeation chromatography, organic elemental analysis, and measurements of softening point, hydroxyl value, and the like.

The condensation reaction for providing the monoalkylnaphthalene formaldehyde resin can also be performed under the coexistence with an alcohol. In the case of the coexistence with an alcohol, the terminal of the resin is sealed to easily provide a monoalkylnaphthalene formaldehyde resin having a low molecular weight and a low dispersion (narrow molecular distribution), and when the resin is modified as described later, a modified resin good in solvent solubility and low in melt viscosity tends to be easily obtained. The alcohol for use therein is not particularly limited, but examples thereof include a monool having 1 to 12 carbon atoms and a diol having 1 to 12 carbon atoms. These alcohols can be used singly or appropriately in combination of two or more. Among them, propanol, butanol, octanol, and 2-ethylhexanol are more preferable from the viewpoint of productivity of the monoalkylnaphthalene formaldehyde resin. Herein, in the case of the coexistence with the alcohol, the amount of the alcohol used is not particularly limited, but is preferably such an amount that the hydroxyl group of the alcohol is 1 to 10 equivalents based on 1 mol of the monoalkylnaphthalene compound represented by the above formula (1), for example.

The monoalkylnaphthalene compound represented by the above formula (1) is limited to a monoalkyl-substituted compound. Examples of such an alkyl group include an alkyl group having 1 to 4 carbon atoms, specifically, a methyl group, an ethyl group, a n-propyl group, an i-propyl group, a n-butyl group, an i-butyl group, and a t-butyl group. Among them, a methyl group or an ethyl group is preferable, and a methyl group is more preferable, from the viewpoint that thermal decomposability is excellent. Such monoalkylnaphthalene compound represented by the above formula (1) can be used singly or appropriately in combination of two or more.

The molecular weight of the monoalkylnaphthalene formaldehyde resin as a starting material is not particularly limited, but the number average molecular weight (Mn) is preferably 300 to 800, more preferably 350 to 700, and further preferably 400 to 600. Similarly, the weight average molecular weight (Mw) of the monoalkylnaphthalene formaldehyde resin is not particularly limited, but is preferably 300 to 2000, more preferably 350 to 1750, and further preferably 400 to 1500. When the molecular weight falls within the above range, the increase in viscosity tends to be suppressed, and also heat resistance tends to be higher. Herein, the dispersivity Mw/Mn is not particularly limited, but is preferably 1.2 to 2.5, more preferably 1.25 to 2.25, and further preferably 1.3 to 2.0.

The softening point of the monoalkylnaphthalene formaldehyde resin as a starting material is not particularly limited, but is preferably 120°C or lower, more preferably 110°C or lower, and further preferably 100°C or lower, from the viewpoints of thermal decomposition resistance and handling.

The hydroxyl value of the monoalkylnaphthalene formaldehyde resin as a starting material is not particularly

limited, but is preferably 10 to 50 mgKOH/g, more preferably 12.5 to 45 mgKOH/g, and further preferably 15 to 40 mgKOH/g, from the viewpoints of thermal decomposition resistance and solubility in a solvent.

<Acidic treatment>

The resin of the present embodiment is obtained by subjecting the monoalkylnaphthalene formaldehyde resin described above to an acidic treatment, or further subjecting the resin which has been subjected to an acidic treatment to a different acidic treatment.
The acidic treatment herein includes the following.

(A) Acidic treatment using an acidic catalyst and a compound represented by the following formula (2).
(B) Acidic treatment using an acidic catalyst and water.

[Formula 5]

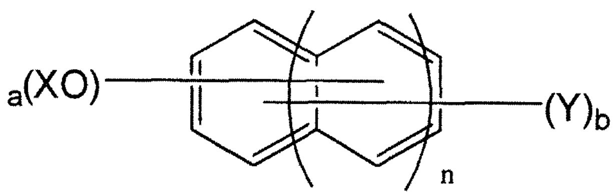

(2)

wherein a represents an integer of 1 to 3, each X independently represents a hydrogen atom, an alkyl group having 1 to 10 carbon atoms, an aryl group having 6 to 10 carbon atoms or a cyclohexyl group, b represents an integer of 0 to 3, each Y independently represents an alkyl group having 1 to 10 carbon atoms, an aryl group having 6 to 10 carbon atoms or a cyclohexyl group, and n represents an integer of 0 to 2.
The operation in the above (A) causes a modification condensation reaction of the monoalkylnaphthalene formaldehyde resin and the compound represented by the above formula (2), resulting in the increases in thermal decomposability and hydroxyl value. Thus, the thermal decomposability of the resulting resin is improved. Herein, such a reaction in (A) is referred to as "modification".
In the monoalkylnaphthalene formaldehyde resin, a naphthalene ring is crosslinked by $-(CH_2)_1-$ and/or $CH_2A-$, wherein 1 represents a number of 1 to 10, A represents $-(OCH_2)_m-$, and m represents a number of 0 to 10. Then, the operation in (B) allows the number of bonds between oxymethylenes via no naphthalene ring to be reduced, resulting in the reduction in number 1 and/or m, that is, resulting in the reduction in number of acetal bonds located at a position via a naphthalene ring. This makes the oxygen concentration lower and the softening point higher. In particular, a resin thus obtained by the operation in (B) followed by the operation in (A) has further improved thermal decomposability as compared with a resin obtained by only the operation in (A). Herein, such a reaction in (B) is referred to as "deacetalization reaction".
Hereinafter, specific aspects obtained by the operations in above (A) and (B) will be described in detail.

<Modified monoalkylnaphthalene formaldehyde resin>

This modified monoalkylnaphthalene formaldehyde resin is obtained by subjecting the monoalkylnaphthalene formaldehyde resin to Acidic treatment (A). That is, the modified monoalkylnaphthalene formaldehyde resin is obtained by heating the alkylnaphthalene formaldehyde resin and the compound represented by the above formula (2) in the presence of an acidic catalyst to modify the monoalkylnaphthalene formaldehyde resin.
In the compound represented by the above formula (2) for use in modifying the monoalkylnaphthalene formaldehyde resin, preferably a represents 1 to 2 and X represents a hydrogen atom, an alkyl group having 1 to 4 carbon atoms, an aryl group having 6 to 10 carbon atoms or a cyclohexyl group; preferably b represents 0 to 2 and Y represents an alkyl group having 1 to 4 carbon atoms, an aryl group having 6 to 10 carbon atoms or a cyclohexyl group; and preferably n represents 0 to 2; in terms of production.
Examples of the compound represented by the above formula (2) include phenol, methoxyphenol, benzoxyphenol, catechol, resorcinol, hydroquinone, cresol, phenylphenol, naphthol, methoxynaphthol, benzoxynaphthol, dihydroxynaphthalene, hydroxyanthracene, methoxyanthracene, benzoxyanthracene, and dihydroxyanthracene. These can be used singly or appropriately in combination of two or more.
Among them, since a phenol derivative including a conjugate structure that involves unshared electron pairs

of at least two benzene rings tends to be more excellent in thermal decomposability, phenylphenol, naphthol, methoxynaphthol, benzoxynaphthol, dihydroxynaphthalene, hydroxyanthracene, methoxyanthracene, benzoxyanthracene, and dihydroxyanthracene are preferable. In addition, among them, since a compound having a hydroxy group tends to be more excellent in crosslinkability with an acid crosslinking agent, phenylphenol, naphthol, dihydroxynaphthalene, hydroxyanthracene, and dihydroxyanthracene are more preferable.

The amount of the compound represented by the above formula (2) used can be appropriately set and is not particularly limited. But the amount is preferably 0.1 to 5 mol, more preferably 0.2 to 4 mol, and further preferably 0.3 to 3 mol, based on 1 mol of oxygen contained in the monoalkylnaphthalene formaldehyde resin. When the compound is used in the above preferable range, the yield of the resulting modified monoalkylnaphthalene formaldehyde resin tends to be kept relatively high, and also the amount of the remaining unreacted compound represented by the above formula (2) can be reduced. Herein, the molar number of oxygen contained in the monoalkylnaphthalene formaldehyde resin can be calculated according to the following expression, wherein the oxygen concentration (% by mass) in the resin is measured by organic elemental analysis.

Expression: molar number of oxygen contained (mol) = amount of resin used (g) × oxygen concentration (% by mass)/16

The modification treatment is usually performed in the presence of an acidic catalyst at ordinary pressure while heating under reflux at a temperature, where raw materials used are compatible, or higher (usually 80 to 300°C), or while water generated being distilled off. In addition, this modification treatment may also be performed under pressure. If necessary, an inert gas such as nitrogen, helium or argon may also be allowed to pass through the system.

If necessary, an inert solvent can also be used in the condensation reaction. Examples of the solvent include aromatic hydrocarbons such as toluene, ethylbenzene and xylene; saturated aliphatic hydrocarbons such as heptane and hexane; alicyclic hydrocarbons such as cyclohexane; ethers such as dioxane and dibutyl ether; alcohols such as 2-propanol; ketones such as methyl isobutyl ketone; carboxylic acid esters such as ethyl propionate; and carboxylic acids such as acetic acid. These solvents can be used singly or appropriately in combination of two or more.

The acidic catalyst used in the modification treatment, while a known one in the art can be used therefor, is not particularly limited, but is preferably an inorganic acid, an organic acid, a Lewis acid or a solid acid. Examples thereof include an inorganic acid such as hydrochloric acid, sulfuric acid, phosphoric acid, hydrobromic acid or hydrofluoric acid, an organic acid such as oxalic acid, malonic acid, succinic acid, adipic acid, sebacic acid, citric acid, fumaric acid, maleic acid, formic acid, p-toluenesulfonic acid, methanesulfonic acid, trifluoroacetic acid, dichloroacetic acid, trichloroacetic acid, trifluoromethanesulfonic acid, benzenesulfonic acid, naphthalenesulfonic acid or naphthalenedisulfonic acid, a Lewis acid such as zinc chloride, aluminum chloride, iron chloride or boron trifluoride, or a solid acid such as tungstosilicic acid, phosphotungstic acid, silicomolybdic acid or phosphomolybdic acid. Among them, sulfuric acid, oxalic acid, citric acid, p-toluenesulfonic acid, methanesulfonic acid, trifluoromethanesulfonic acid, benzenesulfonic acid, naphthalenesulfonic acid, naphthalenedisulfonic acid, and phosphotungstic acid are preferable in terms of production. Herein, such acidic catalysts can be used singly or appropriately in combination of two or more.

The amount of the acidic catalyst used in the modification treatment can be appropriately set and is not particularly limited. But the amount is preferably 0.0001 to 100 parts by mass, more preferably 0.001 to 85 parts by mass, and further preferably 0.001 to 70 parts by mass, based on 100 parts by mass of the monoalkylnaphthalene formaldehyde resin. When the amount falls within the above preferable range, a proper reaction rate tends to be easily obtained, and also the increase in resin viscosity based on a high reaction rate tends to be suppressed. Herein, the acidic catalyst may be collectively charged or may be charged in portions.

The reaction time in the modification treatment can be appropriately set and is not particularly limited, but is preferably 0.5 to 20 hours, more preferably 1 to 15 hours, and further preferably 2 to 10 hours. When the reaction time falls within the preferable range, a resin having the intended properties tends to be easily obtained economically and industrially.

The reaction temperature in the modification treatment can be appropriately set and is not particularly limited, but is preferably 80 to 300°C, more preferably 85 to 270°C, and further preferably 90 to 240°C. When the reaction temperature falls within the preferable range, a resin having the intended properties tends to be easily obtained economically and industrially.

After the completion of the reaction, the acidic catalyst, water, the solvent and/or the unreacted raw materials can be removed according to an ordinary method to provide the modified monoalkylnaphthalene formaldehyde resin. For example, after the completion of the reaction; if necessary, the solvent is added for dilution; washing with water is

performed to thereby completely remove the acidic catalyst; thereafter the resultant is left to still stand to thereby separate two phases; a resin phase as an oil phase and an aqueous phase are separated from each other; and thereafter the solvent added and/or the unreacted raw materials are removed by a common method such as distillation, thereby providing the modified monoalkylnaphthalene formaldehyde resin.

The modified monoalkylnaphthalene formaldehyde resin thus obtained has improved thermal decomposability as compared with the monoalkylnaphthalene formaldehyde resin used as a raw material.

A modified monoalkylnaphthalene formaldehyde resin of a more preferable mode has increased thermal decomposability and hydroxyl value as compared with the monoalkylnaphthalene formaldehyde resin used as a raw material. For example, when the modification is performed under conditions of an amount of the acidic catalyst used of 0.05 parts by mass, a reaction time of 5 hours and a reaction temperature of 200°C, a resin is obtained which has increased thermal decomposability by about 1 to 50% and an increased hydroxyl value by about 1 to 300 mgKOH/g.

The molecular weight of the modified monoalkylnaphthalene formaldehyde resin is not particularly limited, but the number average molecular weight (Mn) is preferably 250 to 1200, more preferably 275 to 1100, and further preferably 300 to 1000. Similarly, the weight average molecular weight (Mw) of the modified monoalkylnaphthalene formaldehyde resin is not particularly limited, but is preferably 300 to 3500, more preferably 350 to 3250, and further preferably 400 to 3000. When the molecular weight falls within the above range, the increase in viscosity tends to be suppressed, and heat resistance tends to be higher. Herein, the dispersivity Mw/Mn is not particularly limited, but is preferably 1.2 to 3.0, more preferably 1.25 to 2.75, and further preferably 1.3 to 2.5.

The softening point of the modified monoalkylnaphthalene formaldehyde resin is not particularly limited, but is preferably 60 to 240°C, more preferably 70 to 230°C, and further preferably 80 to 220°C, from the viewpoints of thermal decomposition resistance and handling.

The hydroxyl value of the modified monoalkylnaphthalene formaldehyde resin is not particularly limited, but is preferably 60 to 260 mgKOH/g, more preferably 70 to 250 mgKOH/g, and further preferably 80 to 240 mgKOH/g, from the viewpoints of thermal decomposition resistance and solubility in a solvent.

The carbon concentration in the modified monoalkylnaphthalene formaldehyde resin is preferably 75.0 to 95.0% by mass, more preferably 77.5 to 94.0% by mass, and further preferably 80.0 to 93.0% by mass, from the viewpoints of thermal decomposability and solubility in a solvent.

The oxygen concentration in the modified monoalkylnaphthalene formaldehyde resin is preferably 2.5 to 15.0% by mass, more preferably 3.0 to 13.0% by mass, and further preferably 3.5 to 11.0% by mass, from the viewpoints of thermal decomposability and solubility in a solvent.

<Deacetalized monoalkylnaphthalene formaldehyde resin>

This deacetalized alkylnaphthalene formaldehyde resin is obtained by subjecting the monoalkylnaphthalene formaldehyde resin to Acidic treatment (B). That is, the deacetalized alkylnaphthalene formaldehyde resin is obtained by treating the alkylnaphthalene formaldehyde resin in the presence of water and an acidic catalyst to reduce the number of acetal bonds.

The acidic catalyst used in the deacetalization reaction treatment, while a known one in the art can be used, is not limited, but is preferably an inorganic acid, an organic acid, a Lewis acid or a solid acid. Examples thereof include inorganic acids such as hydrochloric acid, sulfuric acid, phosphoric acid, hydrobromic acid and hydrofluoric acid; organic acids such as oxalic acid, malonic acid, succinic acid, adipic acid, sebacic acid, citric acid, fumaric acid, maleic acid, formic acid, p-toluenesulfonic acid, methanesulfonic acid, trifluoroacetic acid, dichloroacetic acid, trichloroacetic acid, trifluoromethanesulfonic acid, benzenesulfonic acid, naphthalenesulfonic acid and naphthalenedisulfonic acid; Lewis acids such as zinc chloride, aluminum chloride, iron chloride and boron trifluoride; and solid acids such as tungstosilicic acid, phosphotungstic acid, silicomolybdic acid and phosphomolybdic acid. Among them, sulfuric acid, oxalic acid, citric acid, p-toluenesulfonic acid, methanesulfonic acid, trifluoromethanesulfonic acid, benzenesulfonic acid, naphthalenesulfonic acid, naphthalenedisulfonic acid, and phosphotungstic acid are preferable in terms of production. Herein, such acidic catalysts can be used singly or appropriately in combination of two or more.

The deacetalization reaction treatment in the presence of water and an acidic catalyst is usually performed in the presence of an acidic catalyst at ordinary pressure while water to be used being dropped or sprayed as steam to the system at a temperature, where raw materials used are compatible, or higher (usually 80 to 300°C). Water in the system may be distilled off or refluxed, but is preferably distilled off together with a low boiling point component generated in the reaction, such as formaldehyde, from the viewpoint of effective removal of an acetal bond. In addition, this deacetalization reaction treatment may also be performed under pressure. If necessary, an inert gas such as nitrogen, helium or argon may also be allowed to pass through the system.

If necessary, an inert solvent can also be used in the reaction. Examples of the solvent include aromatic hydrocarbons such as toluene, ethylbenzene and xylene; saturated aliphatic hydrocarbons such as heptane and hexane; alicyclic hydrocarbons such as cyclohexane; ethers such as dioxane and dibutyl ether; alcohols such as 2-propanol;

ketones such as methyl isobutyl ketone; carboxylic acid esters such as ethyl propionate; and carboxylic acids such as acetic acid. These solvents can be used singly or appropriately in combination of two or more.

The amount of the acidic catalyst in the deacetalization reaction treatment can be appropriately set and is not particularly limited, but is preferably 0.0001 to 100 parts by mass, more preferably 0.001 to 85 parts by mass, and further preferably 0.001 to 70 parts by mass, based on 100 parts by mass of the monoalkylnaphthalene formaldehyde resin. When the amount falls within the above preferable range, a proper reaction rate tends to be easily obtained, and also the increase in resin viscosity based on a high reaction rate tends to be suppressed. Herein, the acidic catalyst may be collectively charged or may be charged in portions.

Water used in the deacetalization reaction treatment is not particularly limited as long as it is acceptable to industrial use. Examples include tap water, distilled water, ion-exchange water, pure water or ultrapure water.

The amount of water used in the deacetalization reaction treatment can be appropriately set and is not particularly limited, but is preferably 0.1 to 10000 parts by mass, more preferably 1 to 5000 parts by mass, and further preferably 10 to 3000 parts by mass, based on 100 parts by mass of the monoalkylnaphthalene formaldehyde resin.

The treatment time of the deacetalization reaction treatment can be appropriately set and is not particularly limited, but is preferably 0.5 to 20 hours, more preferably 1 to 15 hours, and further preferably 2 to 10 hours. When the treatment time falls within the preferable range, a resin having the intended properties tends to be easily obtained economically and industrially.

The treatment temperature of the deacetalization reaction treatment can be appropriately set and is not particularly limited, but is preferably 80 to 300°C, more preferably 85 to 270°C, and further preferably 90 to 240°C. When the treatment temperature falls within the preferable range, a resin having the intended properties tends to be easily obtained economically and industrially.

After the completion of the deacetalization reaction treatment, the acidic catalyst, water, the solvent and/or the unreacted raw materials can be removed according to an ordinary method to provide the deacetalized monoalkylnaphthalene formaldehyde resin. For example, after the completion of the reaction; if necessary, the solvent is added for dilution; washing with water is performed to thereby completely remove the acidic catalyst; thereafter the resultant is left to still stand to thereby separate two phases; a resin phase as an oil phase and an aqueous phase are separated from each other; and thereafter the solvent added and/or the unreacted raw materials are removed by a common method such as distillation, thereby providing the deacetalized monoalkylnaphthalene formaldehyde resin.

The deacetalized monoalkylnaphthalene formaldehyde resin thus obtained has a reduced oxygen concentration and an increased softening point as compared with the monoalkylnaphthalene formaldehyde resin used as a raw material. For example, when the treatment is performed under conditions of an amount of the acidic catalyst used of 0.05 parts by mass, an amount of water used of 2000 parts by mass, a treatment time of 5 hours and a treatment temperature of 150°C, a resin is obtained which has a reduced oxygen concentration by about 0.1 to 8.0% by mass and an increased softening point by about 3 to 100°C.

The molecular weight of the deacetalized monoalkylnaphthalene formaldehyde resin is not particularly limited, but the number average molecular weight (Mn) is preferably 250 to 1500, more preferably 275 to 1400, and further preferably 300 to 1300. Similarly, the weight average molecular weight (Mw) of the deacetalized monoalkylnaphthalene formaldehyde resin is not particularly limited, but is preferably 300 to 5000, more preferably 350 to 4500, and further preferably 400 to 4000. When the molecular weight falls within the above range, the increase in viscosity tends to be suppressed, and also heat resistance tends to be higher. Herein, the dispersivity Mw/Mn is not particularly limited, but is preferably 1.2 to 7.0, more preferably 1.25 to 6.75, and further preferably 1.3 to 6.5.

The softening point of the deacetalized monoalkylnaphthalene formaldehyde resin is not particularly limited, but is preferably 50 to 150°C, more preferably 60 to 140°C, and further preferably 70 to 130°C, from the viewpoints of thermal decomposition resistance and handling.

The hydroxyl value of the deacetalized monoalkylnaphthalene formaldehyde resin is not particularly limited, but is preferably 5 to 50 mgKOH/g, more preferably 7.5 to 45 mgKOH/g, and further preferably 10 to 40 mgKOH/g, from the viewpoints of thermal decomposition resistance and solubility in a solvent.

The carbon concentration in the deacetalized monoalkylnaphthalene formaldehyde resin is preferably 75.0 to 95.0% by mass, more preferably 77.5 to 94.0% by mass, and further preferably 80.0 to 93.0% by mass, from the viewpoints of thermal decomposability and solubility in a solvent.

The oxygen concentration in the deacetalized monoalkylnaphthalene formaldehyde resin is preferably 2.5 to 15.0% by mass, more preferably 3.0 to 13.0% by mass, and further preferably 3.5 to 11.0% by mass, from the viewpoints of thermal decomposability and solubility in a solvent.

<Modified deacetalized monoalkylnaphthalene formaldehyde resin>

This modified deacetalized monoalkylnaphthalene formaldehyde resin is obtained by subjecting the monoalkylnaphthalene formaldehyde resin to Acidic treatment (B) and then Acidic treatment (A). That is, the modified deacetalized

monoalkylnaphthalene formaldehyde resin is obtained by heating the aforementioned deacetalized monoalkylnaphthalene formaldehyde resin and a compound represented by the following formula (2) in the presence of an acidic catalyst to modify the deacetalized monoalkylnaphthalene formaldehyde resin.

[Formula 6]

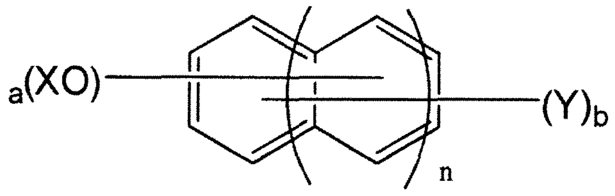

(2)

wherein a represents an integer of 1 to 3, each X independently represents a hydrogen atom, an alkyl group having 1 to 10 carbon atoms, an aryl group having 6 to 10 carbon atoms or a cyclohexyl group, b represents an integer of 0 to 3, each Y independently represents an alkyl group having 1 to 10 carbon atoms, an aryl group having 6 to 10 carbon atoms or a cyclohexyl group, and n represents an integer of 0 to 2.

In the compound represented by the formula (2) used in modifying the deacetalized monoalkylnaphthalene formaldehyde resin, preferably a represents 1 to 2 and X represents a hydrogen atom, an alkyl group having 1 to 4 carbon atoms, an aryl group having 6 to 10 carbon atoms or a cyclohexyl group; preferably b represents 0 to 2 and Y represents an alkyl group having 1 to 4 carbon atoms, an aryl group having 6 to 10 carbon atoms or a cyclohexyl group; and preferably n represents 0 to 2; in terms of production.

Examples of the compound represented by the above formula (2) include phenol, methoxyphenol, benzoxyphenol, catechol, resorcinol, hydroquinone, cresol, phenylphenol, naphthol, methoxynaphthol, benzoxynaphthol, dihydroxynaphthalene, hydroxyanthracene, methoxyanthracene, benzoxyanthracene, and dihydroxyanthracene. These can be used singly or appropriately in combination of two or more.

Among them, since a phenol derivative including a conjugate structure that involves unshared electron pairs of at least two benzene rings tends to be more excellent in thermal decomposability, phenylphenol, naphthol, methoxynaphthol, benzoxynaphthol, dihydroxynaphthalene, hydroxyanthracene, methoxyanthracene, benzoxyanthracene, and dihydroxyanthracene are preferable. In addition, among them, since a compound having a hydroxy group tends to be more excellent in crosslinkability with an acid crosslinking agent, phenylphenol, naphthol, dihydroxynaphthalene, hydroxyanthracene, and dihydroxyanthracene are more preferable.

The amount of the compound represented by the above formula (2) used can be appropriately set and is not particularly limited, but is preferably 0.1 to 5 mol, more preferably 0.2 to 4 mol, and further preferably 0.3 to 3 mol, based on 1 mol of oxygen contained in the deacetalized monoalkylnaphthalene formaldehyde resin. When the compound is used in the above preferable range, the yield of the resulting modified deacetalized monoalkylnaphthalene formaldehyde resin tends to be kept relatively high, and also the amount of the remaining unreacted compound represented by the above formula (2) can be reduced.

The modification treatment after deacetalization is usually performed in the presence of an acidic catalyst at ordinary pressure while heating under reflux at a temperature, where raw materials used are compatible, or higher (usually 80 to 300°C), or while water generated being distilled off. In addition, this modification treatment may also be performed under pressure. If necessary, an inert gas such as nitrogen, helium or argon may also be allowed to pass through the system.

If necessary, an inert solvent can also be used in the condensation reaction. Examples of the solvent include aromatic hydrocarbons such as toluene, ethylbenzene and xylene; saturated aliphatic hydrocarbons such as heptane and hexane; alicyclic hydrocarbons such as cyclohexane; ethers such as dioxane and dibutyl ether; alcohols such as 2-propanol; ketones such as methyl isobutyl ketone; carboxylic acid esters such as ethyl propionate; and carboxylic acids such as acetic acid. These solvents can be used singly or appropriately in combination of two or more.

The acidic catalyst used in the modification treatment after deacetalization, while a known one in the art can be used therefor, is not particularly limited, but is preferably an inorganic acid, an organic acid, a Lewis acid or a solid acid. Examples thereof include an inorganic acid such as hydrochloric acid, sulfuric acid, phosphoric acid, hydrobromic acid or hydrofluoric acid, an organic acid such as oxalic acid, malonic acid, succinic acid, adipic acid, sebacic acid, citric acid, fumaric acid, maleic acid, formic acid, p-toluenesulfonic acid, methanesulfonic acid, trifluoroacetic acid, dichloroacetic acid, trichloroacetic acid, trifluoromethanesulfonic acid, benzenesulfonic acid, naphthalenesulfonic acid or naphthalenedisulfonic acid, a Lewis acid such as zinc chloride, aluminum chloride, iron chloride or boron trifluoride, or a solid acid such as tungstosilicic acid, phosphotungstic acid, silicomolybdic acid or phosphomolybdic acid. Among them, sulfuric acid, oxalic acid, citric acid, p-toluenesulfonic acid, methanesulfonic acid, trifluoromethanesulfonic acid, benzenesulfonic

acid, naphthalenesulfonic acid, naphthalenedisulfonic acid, and phosphotungstic acid are preferable in terms of production. Herein, such acidic catalysts can be used singly or appropriately in combination of two or more.

The amount of the acidic catalyst used in the modification treatment after deacetalization can be appropriately set and is not particularly limited. But the amount is preferably 0.0001 to 100 parts by mass, more preferably 0.001 to 85 parts by mass, and further preferably 0.001 to 70 parts by mass, based on 100 parts by mass of the deacetalized monoalkylnaphthalene formaldehyde resin. When the amount falls within the preferable range, a proper reaction rate tends to be easily obtained, and also the increase in resin viscosity based on a high reaction rate tends to be suppressed. Herein, the acidic catalyst may be collectively charged or may be charged in portions.

The reaction time in the modification treatment after deacetalization can be appropriately set and is not particularly limited, but is preferably 0.5 to 20 hours, more preferably 1 to 15 hours, and further preferably 2 to 10 hours. When the reaction time falls within the preferable range, a resin having the intended properties tends to be easily obtained economically and industrially.

The reaction temperature in the modification treatment after deacetalization can be appropriately set and is not particularly limited, but is preferably 80 to 300°C, more preferably 85 to 270°C, and further preferably 90 to 240°C. When the reaction temperature falls within the above preferable range, a resin having the intended properties tends to be easily obtained economically and industrially.

After the completion of the reaction, the acidic catalyst, water, the solvent and/or the unreacted raw materials can be removed according to an ordinary method to provide the modified deacetalized monoalkylnaphthalene formaldehyde resin. For example, after the completion of the reaction; if necessary, the solvent is added for dilution; washing with water is performed to thereby completely remove the acidic catalyst; thereafter the resultant is left to still stand to thereby separate two phases; a resin phase as an oil phase and an aqueous phase are separated from each other; and thereafter the solvent added and/or the unreacted raw materials are removed by a common method such as distillation, thereby providing the modified deacetalized monoalkylnaphthalene formaldehyde resin.

The modified deacetalized monoalkylnaphthalene formaldehyde resin thus obtained has improved thermal decomposability as compared with the modified monoalkylnaphthalene formaldehyde resin obtained by modifying the monoalkylnaphthalene formaldehyde resin.

In addition, the modified deacetalized monoalkylnaphthalene formaldehyde resin has increased thermal decomposability and hydroxyl value as compared with the deacetalized monoalkylnaphthalene formaldehyde resin. For example, when the modification is performed under conditions of an amount of the acidic catalyst used of 0.05 parts by mass, a reaction time of 5 hours and a reaction temperature of 200°C, a resin is obtained which has increased thermal decomposability by about 1 to 50% and an increased hydroxyl value by about 1 to 300 mgKOH/g.

The molecular weight of the modified deacetalized monoalkylnaphthalene formaldehyde resin is not particularly limited, but the number average molecular weight (Mn) is preferably 250 to 1200, more preferably 275 to 1100, and further preferably 300 to 1000. Similarly, the weight average molecular weight (Mw) of the modified deacetalized monoalkylnaphthalene formaldehyde resin is not particularly limited, but is preferably 300 to 3500, more preferably 350 to 3250, and further preferably 400 to 3000. When the molecular weight falls within the above range, the increase in viscosity tends to be suppressed, and heat resistance tends to be higher. Herein, the dispersivity Mw/Mn is not particularly limited, but is preferably 1.2 to 3.0, more preferably 1.25 to 2.75, and further preferably 1.3 to 2.5.

The softening point of the modified deacetalized monoalkylnaphthalene formaldehyde resin is not particularly limited, but is preferably 60 to 240°C, more preferably 70 to 230°C, and further preferably 80 to 220°C, from the viewpoints of thermal decomposition resistance and handling.

The hydroxyl value of the modified deacetalized monoalkylnaphthalene formaldehyde resin is not particularly limited, but is preferably 50 to 260 mgKOH/g, more preferably 55 to 250 mgKOH/g, and further preferably 60 to 240 mgKOH/g, from the viewpoints of thermal decomposition resistance and solubility in a solvent.

The carbon concentration in the modified deacetalized monoalkylnaphthalene formaldehyde resin is preferably 75.0 to 95.0% by mass, more preferably 77.5 to 94.0% by mass, and further preferably 80.0 to 93.0% by mass, from the viewpoints of thermal decomposability and solubility in a solvent.

The oxygen concentration in the modified deacetalized monoalkylnaphthalene formaldehyde resins is preferably 2.5 to 15.0% by mass, more preferably 3.0 to 13.0% by mass, and further preferably 3.5 to 11.0% by mass, from the viewpoints of thermal decomposability and solubility in a solvent.

[Material for forming an underlayer film, underlayer film, and pattern forming method]

A material for forming an underlayer film of the present embodiment at least contains the modified monoalkylnaphthalene formaldehyde resin and/or modified deacetalized monoalkylnaphthalene formaldehyde resin described above, and an organic solvent.

In the material for forming the underlayer film of the present embodiment, the contents of the modified monoalkylnaphthalene formaldehyde resin and modified deacetalized monoalkylnaphthalene formaldehyde resin described above

can be appropriately set and are not particularly limited. But the total thereof is preferably 1 to 33 parts by mass, more preferably 2 to 30 parts by mass, and further preferably 3 to 25 parts by mass, based on 100 parts by mass of the total amount including the organic solvent.

As the organic solvent used in the above material for forming the underlayer film, a known one can be appropriately used as long as at least the modified monoalkylnaphthalene formaldehyde resin and modified deacetalized monoalkylnaphthalene formaldehyde resin described above are dissolved therein. Specific examples of the organic solvent include ketone-type solvents such as acetone, methyl ethyl ketone, methyl isobutyl ketone and cyclohexanone, cellosolve-type solvents such as propylene glycol monomethyl ether and propylene glycol monomethyl ether acetate, ester-type solvents such as ethyl lactate, methyl acetate, ethyl acetate, butyl acetate, isoamyl acetate, ethyl lactate, methyl methoxypropionate and methyl hydroxyisobutyrate, alcohol-type solvents such as methanol, ethanol, isopropanol and 1-ethoxy-2-propanol, and aromatic hydrocarbons such as toluene, xylene and anisole, but not particularly limited thereto. These organic solvents can be used singly or appropriately in combination of two or more. Among them, cyclohexanone, propylene glycol monomethyl ether, propylene glycol monomethyl ether acetate, ethyl lactate, methyl hydroxyisobutyrate, and anisole are particularly preferable from the viewpoint of safety.

The content of the organic solvent in the material for forming the underlayer film can be appropriately set and is not particularly limited. But the content is preferably 100 to 10,000 parts by mass and more preferably 200 to 5,000 parts by mass, based on 100 parts by mass of the total of the modified monoalkylnaphthalene formaldehyde resin and the modified deacetalized monoalkylnaphthalene formaldehyde resin from the viewpoints of solubility and film formation.

<Other components>

The material for forming the underlayer film of the present embodiment may include other components such as a crosslinking agent, an acid generator and a basic compound, if necessary. Hereinafter, these optional components will be described.

The material for forming the underlayer film of the present embodiment may contain a crosslinking agent from the viewpoint of suppressing intermixing, if necessary. Specific examples of the crosslinking agent usable in the present embodiment include a melamine compound, a guanamine compound, a glycoluril compound or a urea compound, an epoxy compound, a thioepoxy compound, an isocyanate compound, an azide compound, and a compound having a double bond such as an alkenyl ether group and substituted with at least one group selected from a methylol group, an alkoxymethyl group and an acyloxy methyl group, but not particularly limited thereto. Herein, these crosslinking agents can be used singly or appropriately in combination of two or more.

The content of the crosslinking agent in the material for forming the underlayer film can be appropriately set and is not particularly limited. But the content is preferably 5 to 50 parts by mass and more preferably 10 to 40 parts by mass based on 100 by mass of the total of the modified monoalkylnaphthalene formaldehyde resin and the modified deacetalized monoalkylnaphthalene formaldehyde resin. When the content falls within the above preferable range, generation of a mixing phenomenon with a resist layer tends to be suppressed, and also an antireflection effect tends to be higher and film formability after crosslinking tends to be higher.

The material for forming the underlayer film of the present embodiment may contain an acid generator from the viewpoint of further promoting a thermal crosslinking reaction, if necessary. As the acid generator, one that is thermally decomposed to generate an acid, one that is irradiated with light to generate an acid, and the like are known in the art, but any of them can be used. The acid generator includes an onium salt, a diazomethane derivative, a glyoxime derivative, a bissulfone derivative, a sulfonic acid ester of an N-hydroxyimide compound, a β-ketosulfonic acid derivative, a disulfone derivative, a nitrobenzyl sulfonate derivative, and a sulfonic acid ester derivative, but not particularly limited thereto. Herein, these acid generators can be used singly or appropriately in combination of two or more.

The content of the acid generator in the material for forming the underlayer film can be appropriately set and is not particularly limited. But the content is preferably 0.1 to 50 parts by mass and more preferably 0.5 to 40 parts by mass, based on 100 parts by mass of the total of the modified monoalkylnaphthalene formaldehyde resin and the modified deacetalized monoalkylnaphthalene formaldehyde resin. When the content falls within the above preferable range, the amount of an acid generated tends to be higher to result in the increase in crosslinking reaction, and also generation of a mixing phenomenon with a resist layer tends to be suppressed.

The material for forming the underlayer film of the present embodiment may further contain a basic compound from the viewpoint of the improvement in storage stability. The basic compound serves as a quencher against an acid, for preventing the acid generated by the acid generator in a trace amount from promoting the crosslinking reaction. Examples of such a basic compound include primary, secondary and tertiary aliphatic amines, mixed amines, aromatic amines, heterocyclic amines, a nitrogen-containing compound having a carboxyl group, a nitrogen-containing compound having a sulfonyl group, a nitrogen-containing compound having a hydroxyl group, a nitrogen-containing compound having a hydroxylphenyl group, a nitrogen-containing alcoholic compound, an amide derivative, and an imide derivative, but not particularly limited thereto. Herein, such basic compounds can be used singly or appropriately in combination of

two or more.

The content of the basic compound in the material for forming the underlayer film can be appropriately set and is not particularly limited. But the content is preferably 0.001 to 2 parts by mass and more preferably 0.01 to 1 part, based on 100 parts by mass of the total of the modified monoalkylnaphthalene formaldehyde resin and the modified deacetalized monoalkylnaphthalene formaldehyde resin. When the content falls within the preferable range, storage stability tends to be increased with the crosslinking reaction being not excessively impaired.

The material for forming the underlayer film of the present embodiment may further contain additives known in the art, such as an ultraviolet absorber, a surfactant, a colorant and a nonionic surfactant.

[Underlayer film for lithography and multilayer resist pattern forming method]

An underlayer film for lithography of the present embodiment is formed of the aforementioned material for forming the underlayer film. In addition, a multilayer resist pattern forming method of the present embodiment includes forming an underlayer film on a substrate by using the aforementioned material for forming the underlayer film, forming at least one photoresist layer on the underlayer film, then irradiating a required region of the photoresist layer with radiation, and performing alkaline development. Furthermore, multilayer resist pattern forming method of the present embodiment includes forming an underlayer film on a substrate by using the aforementioned material for forming the underlayer film, forming an intermediate layer film on the underlayer film by using a silicon atom-containing resist intermediate layer film material, forming at least one photoresist layer on the intermediate layer film, then irradiating a required region of the photoresist layer with radiation, performing alkaline development to form a resist pattern, thereafter etching the intermediate layer film while the resist pattern serves as a mask, etching the underlayer film while the resulting intermediate layer film pattern serves as an etching mask, and etching the substrate while the resulting underlayer film pattern serves as an etching mask to thereby form a pattern on the substrate.

The underlayer film for lithography of the present embodiment is not particularly limited in terms of the forming method thereof as long as it is formed of the aforementioned material for forming the underlayer film, and any technique known in the art can be applied for forming the film. The underlayer film can be formed by, for example, applying the aforementioned material for forming the underlayer film on the substrate by a known coating method or printing method such as spin coating or screen printing, and then removing an organic solvent by volatilization or the like. When the underlayer film is formed, baking is preferably performed in order to suppress generation of a mixing phenomenon with an upperlayer resist and to promote a crosslinking reaction. In this case, the baking temperature is not particularly limited, but is preferably in a range from 80 to 450°C, and more preferably in a range from 200 to 400°C. In addition, the baking time is also not particularly limited, but is preferably in a range from 10 to 300 seconds. Herein, the thickness of the underlayer film can be appropriately selected depending on the required performance and is not particularly limited, but is usually preferably 30 to 20,000 nm, and more preferably 50 to 15,000 nm. After the underlayer film is prepared, a silicon-containing resist layer, or a monolayer resist made of a usual hydrocarbon is prepared thereon in the case of a two-layer process. After the underlayer film is prepared, a silicon-containing intermediate layer is formed thereon and a silicon-free monolayer resist layer is prepared further thereon in the case of a three-layer process. In this case, a known photoresist material can be used as a photoresist material for forming this resist layer.

After the underlayer film is prepared on the substrate, a silicon-containing resist layer, or a monolayer resist made of a usual hydrocarbon can be prepared on the underlayer film in the case of a two-layer process. After the underlayer film is prepared on the substrate, a silicon-containing intermediate layer can be prepared on the underlayer film and a silicon-free monolayer resist layer can be further prepared on the silicon-containing intermediate layer in the case of a three-layer process. In these cases, a photoresist material used for forming the resist layer can be appropriately selected from known ones, and is not particularly limited.

As the silicon-containing resist material for a two-layer process, a positive type photoresist material in which a silicon atom-containing polymer such as a polysilsesquioxane derivative or a vinylsilane derivative is used as a base polymer from the viewpoint of oxygen gas etching resistance, and which further includes an organic solvent, an acid generator and if necessary a basic compound is preferably used. As the silicon atom-containing polymer, a known polymer used in such a resist material can be used.

As the silicon-containing intermediate layer for a three-layer process, a polysilsesquioxane-based intermediate layer is preferably used. The intermediate layer can be allowed to have the effect as an antireflection film to thereby suppress reflection. For example, when a material including a large number of aromatic groups and having a high substrate etching resistance is used for the underlayer film in a process for 193 nm exposure, the k-value tends to be higher and substrate reflection tends to be higher. But the intermediate layer can suppress reflection to thereby result in a substrate reflection of 0.5% or less. As the intermediate layer having such an antireflection effect, a polysilsesquioxane, into which a light-absorbing group having a phenyl group or a silicon-silicon bond is introduced, and which is to be crosslinked by an acid or heat is preferably used for 193 nm exposure.

An intermediate layer formed by the Chemical Vapour Deposition (CVD) method can also be used. As the

intermediate layer prepared by the CVD method, having a high effect as an antireflection film, for example, a SiON film is known. In general, intermediate layer formation by a wet process such as a spin coating method or screen printing is simpler and more advantageous in terms of cost than that by the CVD method. Herein, the upperlayer resist in a three-layer process may be a positive type or a negative type, and the same one as the monolayer resist which is usually used, can be used therefor.

Furthermore, the underlayer film of the present embodiment can also be used as an antireflection film for a usual monolayer resist or an underlying material for suppression of pattern falling. Since the underlayer film of the present embodiment is excellent in etching resistance for underlying layer processing, it can also be expected to serve as a hardmask for underlying layer processing.

When the above photoresist material is used to form a resist layer, a wet process such as a spin coating method or screen printing is preferably used similarly to the case of forming the above underlayer film. In addition, the resist material is applied by a spin coating method or the like and then usually subjected to prebake, and this prebake is preferably performed at a temperature of 80 to 180°C for a period of 10 to 300 seconds. Thereafter, by performing exposure, post exposure bake (PEB) and development according to an ordinary method, a resist pattern can be obtained. Herein, the thickness of a resist film is not particularly restricted, but is generally preferably 30 to 500 nm and more preferably 50 to 400 nm.

In addition, exposure light may be appropriately selected and used depending on the photoresist material used. In general, examples thereof can include a high energy ray having a wavelength of 300 nm, and specific examples can include excimer lasers of 248 nm, 193 nm and 157 nm, a soft X-ray of 3 to 20 nm, an electron beam and an X-ray.

The resist pattern formed by the above method is suppressed by the underlayer film of the present embodiment in terms of pattern falling. Therefore, the underlayer film of the present embodiment can be used to thereby provide a finer pattern, and to reduce an exposure amount required for providing the resist pattern.

Then, the resulting resist pattern is used as a mask for etching. For etching the underlayer film in a two-layer process, gas etching is preferably used. The suitably etching is a gas etching with oxygen gas. In addition to oxygen gas, an inert gas such as He or Ar, or CO, $CO_2$, $NH_3$, $SO_2$, $N_2$, $NO_2$ or $H_2$ gas can also be added. In addition, the gas etching can also be performed by only CO, $CO_2$, $NH_3$, $N_2$, $NO_2$ or $H_2$ gases without oxygen gas. In particular, the latter gas is used for side wall protection for preventing undercut of a pattern side wall. On the other hand, gas etching is preferably used also in etching of the intermediate layer in a three-layer process. As the gas etching, the same as that described in a two-layer process can be applied. In particular, the intermediate layer in a three-layer process can be processed by using a Freon-based gas with the resist pattern as a mask. Thereafter, an intermediate layer pattern can be used as a mask as described above to perform, for example, oxygen gas etching, thereby processing the underlayer film.

When an inorganic hardmask intermediate layer film is formed as the intermediate layer, a silicon oxide film, a silicon nitride film or a silicon oxide nitride film (SiON film) is formed by the CVD method or the ALD method. A method for forming a nitride film is described in, for example, Japanese Patent Laid-Open No. 2002-334869 (Patent Literature 6) and WO2004/066377 (Patent Literature 7). While a photoresist film can be directly formed on such an intermediate layer film, an organic antireflection film (BARC) may also be formed on the intermediate layer film by spin coating and a photoresist film may also be formed thereon.

As the intermediate layer, a polysilsesquioxane-based intermediate layer is also preferably used. The resist intermediate layer film can be allowed to have the effect as an antireflection film, thereby suppressing reflection. A material for the polysilsesquioxane-based intermediate layer is specifically described in, for example, Japanese Patent Laid-Open No. 2007-226170 (Patent Literature 8) and Japanese Patent Laid-Open No. 2007-226204 (Patent Literature 9).

In addition, the next etching of the substrate can also be performed by an ordinary method. For example, when the substrate is made of $SiO_2$ or SiN, etching mainly with a Freon-based gas can be performed, and when the substrate is made of p-Si, Al or W, etching mainly with a chlorine-based or bromine-based gas can be performed. When processing of the substrate is performed by etching with a Freon-based gas, the silicon-containing resist in a two-layer resist process and the silicon-containing intermediate layer in a three-layer process are peeled at the same time of processing of the substrate. On the other hand, in case where the substrate is etched by a chlorine-based or bromine-based gas, the silicon-containing resist layer or the silicon-containing intermediate layer is separately peeled, and in general, peeled by dry etching with a Freon-based gas after processing of the substrate.

The underlayer film of the present embodiment is characterized by being excellent in etching resistance of the substrate. Herein, the substrate, while a known one can be appropriately selected and used therefor without particular limitation, but includes Si, $\alpha$-Si, p-Si, $SiO_2$ SiN, SiON, W, TiN and Al. In addition, the substrate may also be a laminate having a film to be processed (substrate to be processed) on a base material (support). Such a film to be processed includes various Low-k films such as Si, $SiO_2$, SiON, SiN, p-Si, $\alpha$-Si, W, W-Si, Al, Cu and Al-Si, and stopper films thereof, and a film made of a material different from the base material (support) is usually used. Herein, the thickness of the substrate to be processed or the film to be processed is not particularly limited, but is usually preferably about 50 to 10,000 nm, and more preferably 75 to 5,000 nm.

Examples

Hereinafter, the present invention will be further described with reference to Synthesis Examples and Examples, but the present invention is not limited by these Examples at all.

Herein, the following measurements and evaluations were performed under the following conditions.

<Molecular weights>

The weight average molecular weight (Mw) and the number average molecular weight (Mn) in terms of polystyrene were determined by gel permeation chromatography (GPC) analysis, and the dispersivity (Mw/Mn) was determined.
Apparatus: Shodex GPC-101 Model (manufactured by Showa Denko K. K.)
Column: LF-804 x 3
Eluent: THF 1 ml/min
Temperature: 40°C

<Carbon concentration and oxygen concentration in resin>

The carbon concentration and the oxygen concentration (% by mass) in a resin were measured by organic elemental analysis. In addition, the molar number of oxygen contained in 1 g of a resin was calculated according to the following expression. Apparatus: CHN Corder MT-6 (manufactured by Yanaco Bunseki Kogyo Co.)

Expression: molar number of oxygen contained in 1 g of resin (mol/g) = oxygen concentration (% by mass)/16

<Softening point>

The softening point of a resin was measured according to JIS-K5601.

<Thermal decomposability>

The thermal weight loss rate (amount thermally decomposed (%)) when the temperature reached 400°C was measured.
Apparatus: TG/DTA6200 (manufactured by SII Nanotechnology Inc.)
Measurement temperature: 30 to 550°C (rate of temperature rise: 10°C/min)
Measurement atmosphere: under air flowing

<Hydroxyl value>

The hydroxyl value of a resin was measured according to JIS-K1557.

<Film thickness reduction rate>

A cyclohexanone resin solution containing a resin to be measured in a concentration of 20 wt% was uniformly applied on a Si wafer having a square of 2 cm by using a spin coater with rotation at 4000 rpm for 60 seconds. Then, the thickness $T_0$ of a film on the Si wafer was measured by using an ellipsometer. Then, the Si wafer was baked at 400°C for 120 seconds by using a baking apparatus, and the thickness $T_1$ of the film after baking was measured. Then, the reduction rate was calculated according to the following expression based on the thicknesses before and after baking.

$$\text{Film thickness reduction rate (\%)} = 100 \times (T_0 - T_1)/T_0$$

<Synthesis Example 1>

A bottom-removable four-necked flask having an inner volume of 1 L and equipped with a Dimroth condenser,

a thermometer and a stirring blade was charged with 71.1 g of 1-methylnaphthalene (0.5 mol, produced by Kanto Chemical Co., Inc.), 150 g of an aqueous 40% by mass formalin solution (2 mol as formaldehyde, produced by Mitsubishi Gas Chemical Company, Inc.) and 72.7 g of 98% by mass sulfuric acid (produced by Kanto Chemical Co., Inc.) under a nitrogen stream, and the content of the flask was reacted while stirring under reflux at ordinary pressure at 100°C for 6 hours. Thereto was added 150 g of ethylbenzene (produced by Kanto Chemical Co., Inc.) as a dilution solvent and left to still stand, and then an aqueous phase as a lower phase was removed. Furthermore, the resultant was subjected to neutralization and washing with water, and ethylbenzene and unreacted 1-methylnaphthalene were distilled off under reduced pressure to thereby provide 80.3 g of a monomethylnaphthalene formaldehyde resin as a light yellow solid.

As the GPC measurement results, the Mn was 486, the Mw was 948, and the Mw/Mn was 1.95. As the results of organic elemental analysis, the carbon concentration was 85.1% by mass, and the oxygen concentration was 8.3% by mass (the molar number of oxygen contained in 1 g of the resin was 0.0052 mol/g). The softening point was 82°C and the hydroxyl value was 27 mgKOH/g.

<Synthesis Example 2>

A bottom-removable three-necked flask having an inner volume of 0.1 L and equipped with a Dimroth condenser, a thermometer and a stirring blade was charged with 7.8 g of 1-ethylnaphthalene (0.05 mol, produced by Kanto Chemical Co., Inc.), 15g of an aqueous 40% by mass formalin solution (0.2 mol as formaldehyde, produced by Mitsubishi Gas Chemical Company, Inc.) and 72.7 g of 98% by mass sulfuric acid (produced by Kanto Chemical Co., Inc.) under a nitrogen stream, and the content of the flask was reacted while stirring under reflux at ordinary pressure at 100°C for 6 hours. Thereto was added 15 g of ethylbenzene (produced by Kanto Chemical Co., Inc.) as a dilution solvent and left to still stand, and then an aqueous phase as a lower phase was removed. Furthermore, the resultant was subjected to neutralization and washing with water, and ethylbenzene and unreacted 1-ethylnaphthalene were distilled off under reduced pressure to thereby provide 8.9 g of a monoethylnaphthalene formaldehyde resin as a light yellow solid.

As the GPC measurement results, the Mn was 504, the Mw was 977, and the Mw/Mn was 1.94. As the results of organic elemental analysis, the carbon concentration was 84.5% by mass, and the oxygen concentration was 8.5% by mass (the molar number of oxygen contained in 1 g of the resin was 0.053 mol/g). The softening point was 79°C and the hydroxyl value was 22 mgKOH/g.

<Comparative Synthesis Example 1>

A bottom-removable four-necked flask having an inner volume of 1 L and equipped with a Dimroth condenser, a thermometer and a stirring blade was charged with 78.1 g of 1,5-dimethylnaphthalene (0.5 mol, produced by Mitsubishi Gas Chemical Company, Inc.), 150g of an aqueous 40% by mass formalin solution (2 mol as formaldehyde, produced by Mitsubishi Gas Chemical Company, Inc.) and 66.2 g of 98% by mass sulfuric acid (produced by Kanto Chemical Co., Inc.) under a nitrogen stream, and the content of the flask was reacted while stirring under reflux at ordinary pressure and at 100°C for 6 hours. Thereto was added 150 g of ethylbenzene (produced by Kanto Chemical Co., Inc.) as a dilution solvent and left to still stand, and then an aqueous phase as a lower phase was removed. Furthermore, the resultant was subjected to neutralization and washing with water, and ethylbenzene and unreacted 1,5-dimethylnaphthalene were distilled off under reduced pressure to thereby provide 92.4 g of a dimethylnaphthalene formaldehyde resin as a light yellow solid.

As the GPC measurement results, the Mn was 526, the Mw was 992, and the Mw/Mn was 1.89. As the results of organic elemental analysis, the carbon concentration was 83.9% by mass, and the oxygen concentration was 8.6% by mass (the molar number of oxygen contained in 1 g of the resin was 0.0054 mol/g). The softening point was 81°C and the hydroxyl value was 19 mgKOH/g.

<Example 1>

A four-necked flask having an inner volume of 0.5 L and equipped with a Liebig condenser, a thermometer and a stirring blade was charged with 24.0 g (the molar number of oxygen contained was 0.125 mol) of the monomethylnaphthalene formaldehyde resin obtained in Synthesis Example 1 and 36.1 g of 1-naphthol (0.25 mol, produced by Tokyo Chemical Industry, Co., Ltd.) under a nitrogen stream for heating and melting at 120°C, and 1.8 mg of paratoluenesulfonic acid (produced by Wako Pure Chemical Industries, Ltd.) was then added with stirring, to start the reaction. After the resultant was immediately heated to raise its temperature to 190°C and retained with stirring for 3 hours, 1.2 mg of paratoluenesulfonic acid (produced by Wako Pure Chemical Industries, Ltd.) was added, and the resultant was further heated to raise its temperature to 220°C for the reaction for 2 hours (5 hours in total). After dilution with 150 g of a mixed solvent (metaxylene (produced by Mitsubishi Gas Chemical Company, Inc.)/methyl isobutyl ketone (produced by Kanto Chemical Co., Inc.) = 1/1 (weight ratio)), the resultant was subjected to neutralization and washing with water,

and the solvent was removed under reduced pressure to thereby provide 40.0 g of a modified monomethylnaphthalene formaldehyde resin as a blackish brown solid.

As the GPC measurement results, the Mn was 463 the Mw was 682, and the Mw/Mn was 1.47. As the results of organic elemental analysis, the carbon concentration was 89.4% by mass, and the oxygen concentration was 5.0% by mass. The thermal weight loss rate (%) when the temperature reached 400°C was 17%. The softening point was 134°C and the hydroxyl value was 197 mgKOH/g. In addition, the resulting resin was soluble in a weight ratio, resin/propylene glycol monomethyl ether acetate (PGMEA), of 1/9.

<Example 2>

A four-necked flask having an inner volume of 0.5 L and equipped with a Dean-Stark tube having a Dimroth condenser set thereto, a thermometer and a stirring blade was charged with 50.0 g of the monomethylnaphthalene formaldehyde resin obtained in Synthesis Example 1, 50 g of ethylbenzene (produced by Kanto Chemical Co., Inc.) and 50 g of methyl isobutyl ketone (produced by Kanto Chemical Co., Inc.) for dissolving at 120°C, and 2.5 mg of paratoluenesulfonic acid (produced by Wako Pure Chemical Industries, Ltd.) was added thereto under steam flowing with stirring, to start the reaction. After 2 hours, 1.3 mg of paratoluenesulfonic acid (produced by Wako Pure Chemical Industries, Ltd.) was further added thereto for the reaction for further 3 hours (5 hours in total). After dilution with 150 g of ethylbenzene (produced by Kanto Chemical Co., Inc.), the resultant was subjected to neutralization and washing with water, and the solvent was removed under reduced pressure to thereby provide 41.2 g of a deacetalized monomethylnaphthalene formaldehyde resin as a light red solid.

As the GPC measurement results, the Mn was 326, the Mw was 851, and the Mw/Mn was 2.61. As the results of organic elemental analysis, the carbon concentration was 86.7% by mass, and the oxygen concentration was 6.1% by mass (the molar number of oxygen contained in 1 g of the resin was 0.0038 mol/g). The softening point was 104°C and the hydroxyl value was 30 mgKOH/g.

<Example 3>

A four-necked flask having an inner volume of 0.3 L and equipped with a Liebig condenser, a thermometer and a stirring blade was charged with 39.5 g (the molar number of oxygen contained was 0.15 mol) of the deacetalized monomethylnaphthalene formaldehyde resin obtained in Example 2 and 43.3 g of 1-naphthol (0.30 mol, produced by Tokyo Chemical Industry, Co., Ltd.) under a nitrogen stream for heating and melting at 120°C, and 2.5 mg of paratoluenesulfonic acid (produced by Wako Pure Chemical Industries, Ltd.) was then added with stirring, to start the reaction. After the resultant was immediately heated to raise its temperature to 190°C and retained with stirring for 3 hours, 1.7 mg of paratoluenesulfonic acid (produced by Wako Pure Chemical Industries, Ltd.) was added, and the resultant was further heated to raise its temperature to 220°C for the reaction for 2 hours (5 hours in total). After dilution with 180 g of a mixed solvent (metaxylene (produced by Mitsubishi Gas Chemical Company, Inc.)/methyl isobutyl ketone (produced by Kanto Chemical Co., Inc.) = 1/1 (weight ratio)), the resultant was subjected to neutralization and washing with water, and the solvent was removed under reduced pressure to thereby provide 48.9 g of a modified deacetalized monomethylnaphthalene formaldehyde resin as a blackish brown solid.

As the GPC measurement results, the Mn was 504, the Mw was 761, and the Mw/Mn was 1.51. As the results of organic elemental analysis, the carbon concentration was 89.6% by mass, and the oxygen concentration was 4.9% by mass. The thermal weight loss rate (%) when the temperature reached 400°C was 10%. The softening point was 138°C and the hydroxyl value was 193 mgKOH/g. In addition, the resulting resin was soluble in a weight ratio, resin/propylene glycol monomethyl ether acetate (PGMEA), of 1/9.

<Example 4>

A three-necked flask having an inner volume of 0.05 L and equipped with a Liebig condenser, a thermometer and a stirring blade was charged with 2.4 g (the molar number of oxygen contained was 0.0125 mol) of the monoethylnaphthalene formaldehyde resin obtained in Synthesis Example 2 and 3.6 g of 1-naphthol (0.025 mol, produced by Tokyo Chemical Industry, Co., Ltd.) under a nitrogen stream for heating and melting at 120°C, and 0.2 mg of paratoluenesulfonic acid (produced by Wako Pure Chemical Industries, Ltd.) was then added with stirring, to start the reaction. After the resultant was immediately heated to raise its temperature to 190°C and retained with stirring for 3 hours, 0.1 mg of paratoluenesulfonic acid (produced by Wako Pure Chemical Industries, Ltd.) was added, and the resultant was further heated to raise its temperature to 220°C for the reaction for 2 hours (5 hours in total). After dilution with 15 g of a mixed solvent (metaxylene (produced by Mitsubishi Gas Chemical Company, Inc.)/methyl isobutyl ketone (produced by Kanto Chemical Co., Inc.) = 1/1 (weight ratio)), the resultant was subjected to neutralization and washing with water, and the solvent was removed under reduced pressure to thereby provide 3.8 g of a modified monoethylnaphthalene

formaldehyde resin as a blackish brown solid.

As the GPC measurement results, the Mn was 489, the Mw was 703, and the Mw/Mn was 1.44. As the results of organic elemental analysis, the carbon concentration was 89.3% by mass, and the oxygen concentration was 5.0% by mass. The thermal weight loss rate (%) when the temperature reached 400°C was 23%. The softening point was 129°C and the hydroxyl value was 195 mgKOH/g. In addition, the resulting resin was soluble in a weight ratio, resin/propylene glycol monomethyl ether acetate (PGMEA), of 1/9.

<Example 5>

A three-necked flask having an inner volume of 0.05 L and equipped with a Dean-Stark tube having a Dimroth condenser set thereto, a thermometer and a stirring blade was charged with 5.0 g of the monoethylnaphthalene formaldehyde resin obtained in Synthesis Example 2, 5 g of ethylbenzene (produced by Kanto Chemical Co., Inc.) and 5 g of methyl isobutyl ketone (produced by Kanto Chemical Co., Inc.) for dissolving at 120°C, and 0.3 mg of paratoluenesulfonic acid (produced by Wako Pure Chemical Industries, Ltd.) was added thereto under steam flowing with stirring, to start the reaction. After 2 hours, 0.1 mg of paratoluenesulfonic acid (produced by Wako Pure Chemical Industries, Ltd.) was further added thereto for the reaction for further 3 hours (5 hours in total). After dilution with 15 g of ethylbenzene (produced by Kanto Chemical Co., Inc.), the resultant was subjected to neutralization and washing with water, and the solvent was removed under reduced pressure to thereby provide 4.0 g of a deacetalized monoethylnaphthalene formaldehyde resin as a light red solid.

As the GPC measurement results, the Mn was 359, the Mw was 908, and the Mw/Mn was 2.53. As the results of organic elemental analysis, the carbon concentration was 86.3% by mass, and the oxygen concentration was 6.3% by mass (the molar number of oxygen contained in 1 g of the resin was 0.0039 mol/g). The softening point was 98°C and the hydroxyl value was 32 mgKOH/g.

<Example 6>

A three-necked flask having an inner volume of 0.05 L and equipped with a Liebig condenser, a thermometer and a stirring blade was charged with 3.8 g (the molar number of oxygen contained was 0.015 mol) of the deacetalized monoethylnaphthalene formaldehyde resin obtained in Example 5 and 4.3 g of 1-naphthol (0.030 mol, produced by Tokyo Chemical Industry, Co., Ltd.) under a nitrogen stream for heating and melting at 120°C, and 0.3 mg of paratoluenesulfonic acid (produced by Wako Pure Chemical Industries, Ltd.) was then added with stirring, to start the reaction. After the resultant was immediately heated to raise its temperature to 190°C and retained with stirring for 3 hours, 0.2 mg of paratoluenesulfonic acid (produced by Wako Pure Chemical Industries, Ltd.) was added, and the resultant was further heated to raise its temperature to 220°C for the reaction for 2 hours (5 hours in total). After dilution with 18 g of a mixed solvent (metaxylene (produced by Mitsubishi Gas Chemical Company, Inc.)/methyl isobutyl ketone (produced by Kanto Chemical Co., Inc.) = 1/1 (weight ratio)), the resultant was subjected to neutralization and washing with water, and the solvent was removed under reduced pressure to thereby provide 6.6 g of a modified deacetalized monoethylnaphthalene formaldehyde resin as a blackish brown solid.

As the GPC measurement results, the Mn was 539, the Mw was 832, and the Mw/Mn was 1.54. As the results of organic elemental analysis, the carbon concentration was 89.7% by mass, and the oxygen concentration was 4.9% by mass. The thermal weight loss rate (%) when the temperature reached 400°C was 16%. The softening point was 132°C and the hydroxyl value was 192 mgKOH/g. In addition, the resulting resin was soluble in a weight ratio, resin/propylene glycol monomethyl ether acetate (PGMEA), of 1/9.

<Comparative Example 1>

A four-necked flask having an inner volume of 0.5 L and equipped with a Liebig condenser, a thermometer and a stirring blade was charged with 23.1 g (the molar number of oxygen contained was 0.125 mol) of the dimethylnaphthalene formaldehyde resin obtained in Comparative Synthesis Example 1 and 36.6 g of 1-naphthol (0.25 mol, produced by Tokyo Chemical Industry, Co., Ltd.) under a nitrogen stream for heating and melting at 120°C, and 1.8 mg of paratoluenesulfonic acid (produced by Wako Pure Chemical Industries, Ltd.) was then added with stirring, to start the reaction. After the resultant was immediately heated to raise its temperature to 190°C and retained with stirring for 3 hours, 1.2 mg of paratoluenesulfonic acid (produced by Wako Pure Chemical Industries, Ltd.) was added, and the resultant was further heated to raise its temperature to 220°C for the reaction for 2 hours (5 hours in total). After dilution with 150 g of a mixed solvent (metaxylene (produced by Mitsubishi Gas Chemical Company, Inc.)/methyl isobutyl ketone (produced by Kanto Chemical Co., Inc.) = 1/1 (weight ratio)), the resultant was subjected to neutralization and washing with water, and the solvent was removed under reduced pressure to thereby provide 39.7 g of a modified dimethylnaphthalene formaldehyde resin as a blackish brown solid.

As the GPC measurement results, the Mn was 462, the Mw was 693, and the Mw/Mn was 1.50. As the results of organic elemental analysis, the carbon concentration was 89.3% by mass, and the oxygen concentration was 4.7% by mass. The thermal weight loss rate (%) when the temperature reached 400°C was 32%. The softening point was 136°C and the hydroxyl value was 195 mgKOH/g. In addition, the resulting resin was soluble in a weight ratio, resin/propylene glycol monomethyl ether acetate (PGMEA), of 1/9.

<Comparative Example 2>

A four-necked flask having an inner volume of 0.5 L and equipped with a Dean-Stark tube having a Dimroth condenser set thereto, a thermometer and a stirring blade was charged with 50.0 g of the dimethylnaphthalene formaldehyde resin obtained in Synthesis Example 1, 50 g of ethylbenzene (produced by Kanto Chemical Co., Inc.) and 50 g of methyl isobutyl ketone (produced by Kanto Chemical Co., Inc.) for dissolving at 120°C, and 2.5 mg of paratoluenesulfonic acid (produced by Wako Pure Chemical Industries, Ltd.) was added thereto under steam flowing with stirring, to start the reaction. After 2 hours, 1.3 mg of paratoluenesulfonic acid (produced by Wako Pure Chemical Industries, Ltd.) was further added thereto for the reaction for further 3 hours (5 hours in total). After dilution with 150 g of ethylbenzene (produced by Kanto Chemical Co., Inc.), the resultant was subjected to neutralization and washing with water, and the solvent was removed under reduced pressure to thereby provide 40.0 g of a deacetalized dimethylnaphthalene formaldehyde resin as a light red solid.

As the GPC measurement results, the Mn was 360, the Mw was 911, and the Mw/Mn was 2.52. As the results of organic elemental analysis, the carbon concentration was 86.2% by mass, and the oxygen concentration was 6.3% by mass (the molar number of oxygen contained in 1 g of the resin was 0.0039 mol/g). The softening point was 99°C and the hydroxyl value was 31 mgKOH/g.

<Comparative Example 3>

A four-necked flask having an inner volume of 0.3 L and equipped with a Liebig condenser, a thermometer and a stirring blade was charged with 38.5 g (the molar number of oxygen contained was 0.15 mol) of the deacetalized dimethylnaphthalene formaldehyde resin obtained in Comparative Example 2 and 43.3 g of 1-naphthol (0.30 mol, produced by Tokyo Chemical Industry, Co., Ltd.) under a nitrogen stream for heating and melting at 120°C, and 2.5 mg of paratoluenesulfonic acid (produced by Wako Pure Chemical Industries, Ltd.) was then added with stirring, to start the reaction. After the resultant was immediately heated to raise its temperature to 190°C and retained with stirring for 3 hours, 1.6 mg of paratoluenesulfonic acid (produced by Wako Pure Chemical Industries, Ltd.) was added, and the resultant was further heated to raise its temperature to 220°C for the reaction for 2 hours (5 hours in total). After dilution with 180 g of a mixed solvent (metaxylene (produced by Mitsubishi Gas Chemical Company, Inc.)/methyl isobutyl ketone (produced by Kanto Chemical Co., Inc.) = 1/1 (weight ratio)), the resultant was subjected to neutralization and washing with water, and the solvent was removed under reduced pressure to thereby provide 49.1 g of a modified deacetalized dimethylnaphthalene formaldehyde resin as a blackish brown solid.

As the GPC measurement results, the Mn was 512, the Mw was 780, and the Mw/Mn was 1.52. As the results of organic elemental analysis, the carbon concentration was 89.6% by mass, and the oxygen concentration was 4.6% by mass. The thermal weight loss rate (%) when the temperature reached 400°C was 26%. The softening point was 140°C and the hydroxyl value was 191 mgKOH/g. In addition, the resulting resin was soluble in a weight ratio, resin/propylene glycol monomethyl ether acetate (PGMEA), of 1/9.

[Table 1]

| | | Example 1 | Example 3 | Comparative Example 1 | Comparative Example 3 | Example 4 | Example 6 |
|---|---|---|---|---|---|---|---|
| Film thickness reduction rate | % | 32.2% | 29.1% | 36.8% | 33.8% | 33.3% | 30.4% |
| | Class* | B | A | D | C | C | B |
| Thermal weight loss rate@400°C Air | | 17% | 10% | 32% | 26% | 23% | 16% |

(continued)

| | | Example 1 | Example 3 | Comparative Example 1 | Comparative Example 3 | Example 4 | Example 6 |
|---|---|---|---|---|---|---|---|
| Solubility in PGMEA (10wt%) | | ○ | ○ | ○ | ○ | ○ | ○ |
| * Classification in terms of film thickness reduction rate<br>A <30%<br>B 30-32.5%<br>C 32.6%-34.9%<br>D >36% | | | | | | | |

It can be seen from Table 1 that the modified monomethylnaphthalene formaldehyde resin and the modified deacetalized monomethylnaphthalene formaldehyde resin are excellent in thermal decomposability and also excellent in solubility in propylene glycol monomethyl ether acetate (PGMEA) as compared with the modified dimethylnaphthalene formaldehyde resin.

It is to be noted that the present application claims the priority based on Japanese Patent Application (Japanese Patent Application No. 2012-039501) filed with JPO on February 27, 2012 and the content thereof is herein incorporated by reference.

Industrial Applicability

The monoalkylnaphthalene formaldehyde resin subjected to a modification treatment and the modified deacetalized monomethylnaphthalene formaldehyde resin of the present invention are excellent in thermal decomposability and solubility in a solvent, and thus can be widely and effectively utilized in various applications in which these performances are required. In particular, these resins can be particularly effectively utilized as a thermosetting resin used in electrically insulating materials, resist resins, semiconductor sealing resins, adhesives for printed wiring boards; matrix resins for electrical laminated plates mounted on electric equipment, electronic equipment, industrial equipment and the like; matrix resins for prepregs mounted on electric equipment, electronic equipment, industrial equipment and the like; materials for build-up laminated plates, resins for fiber-reinforced plastics, sealing resins for liquid crystal display panels, paints, various coating agents, adhesives, coating agents for semiconductors, underlayer film forming resins, or resist resins for semiconductor manufacturing.

## Claims

1. A resin obtained by subjecting a monoalkylnaphthalene formaldehyde resin to an acidic treatment, wherein the monoalkylnaphthalene formaldehyde resin is obtained by reacting a compound represented by the following formula (1) and formaldehyde in the presence of a catalyst:

[Formula 1]

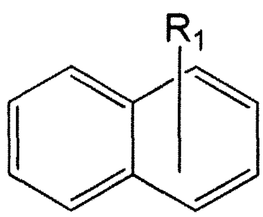

(1)

wherein $R_1$ represents an alkyl group having 1 to 4 carbon atoms.

2. The resin according to claim 1, wherein the acidic treatment is a treatment using an acidic catalyst and a compound represented by the following formula (2):

[Formula 2]

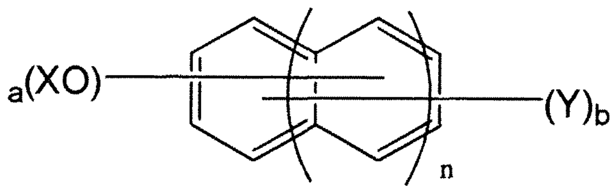

(2)

wherein a represents an integer of 1 to 3, each X independently represents a hydrogen atom, an alkyl group having 1 to 10 carbon atoms, an aryl group having 6 to 10 carbon atoms or a cyclohexyl group, b represents an integer of 0 to 3, each Y independently represents an alkyl group having 1 to 10 carbon atoms, an aryl group having 6 to 10 carbon atoms or a cyclohexyl group, and n represents an integer of 0 to 2.

**3.** The resin according to claim 2, wherein the compound represented by the formula (2) is at least one selected from the group consisting of phenylphenol, naphthol, methoxynaphthol, benzoxynaphthol, dihydroxynaphthalene, hydroxyanthracene, methoxyanthracene, benzoxyanthracene and dihydroxyanthracene.

**4.** The resin according to claim 2 or 3, wherein an amount of the compound represented by the formula (2) used is 0.1 to 5 mol based on 1 mol of oxygen contained in the monoalkylnaphthalene formaldehyde resin.

**5.** The resin according to claim 1, wherein the acidic treatment is a treatment using an acidic catalyst and water.

**6.** The resin according to claim 5, wherein an amount of the acidic catalyst used is 0.0001 to 100 parts by mass based on 100 parts by mass of the monoalkylnaphthalene formaldehyde resin.

**7.** A resin obtained by subjecting the resin according to claim 5 or 6 to an acidic treatment using the acidic catalyst and the compound represented by the formula (2).

**8.** The resin according to claim 7, wherein the compound represented by the formula (2) is at least one selected from the group consisting of phenylphenol, naphthol, methoxynaphthol, benzoxynaphthol, dihydroxynaphthalene, hydroxyanthracene, methoxyanthracene, benzoxyanthracene and dihydroxyanthracene.

**9.** The resin according to claim 7 or 8, wherein an amount of the compound represented by the formula (2) used is 0.1 to 5 mol based on 1 mol of oxygen contained in the monoalkylnaphthalene formaldehyde resin.

**10.** An underlayer film resin obtained by subjecting a monoalkylnaphthalene formaldehyde resin to an acidic treatment, wherein the monoalkylnaphthalene formaldehyde resin is obtained by reacting a compound represented by the following formula (1) and formaldehyde in the presence of a catalyst:

[Formula 3]

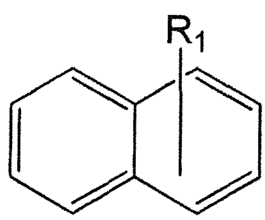

(1)

wherein $R_1$ represents an alkyl group having 1 to 4 carbon atoms.

**11.** The underlayer film resin according to claim 10, wherein the acidic treatment is performed by using an acidic catalyst and a compound represented by the following formula (2):

[Formula 4]

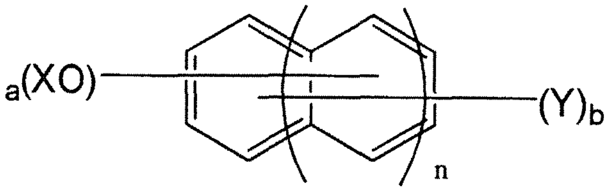

(2)

wherein a represents an integer of 1 to 3, each X independently represents a hydrogen atom, an alkyl group having 1 to 10 carbon atoms, an aryl group having 6 to 10 carbon atoms or a cyclohexyl group, b represents an integer of 0 to 3, each Y independently represents an alkyl group having 1 to 10 carbon atoms, an aryl group having 6 to 10 carbon atoms or a cyclohexyl group, and n represents an integer of 0 to 2; and/or performed using an acidic catalyst and water.

**12.** A material for forming an underlayer film comprising at least the resin according to claim 1 and an organic solvent.

**13.** The material for forming the underlayer film according to claim 12, further comprising an acid generator.

**14.** The material for forming the underlayer film according to claim 12 or 13, further comprising a crosslinking agent.

**15.** An underlayer film for lithography, formed of the material for forming the underlayer film according to any one of claims 12 to 14.

**16.** A pattern forming method comprising forming an underlayer film on a substrate by using the material for forming the underlayer film according to any one of claims 12 to 14, forming at least one photoresist layer on the underlayer film, then irradiating a required region of the photoresist layer with radiation, and performing alkaline development.

**17.** A pattern forming method comprising forming an underlayer film on a substrate by using the material for forming the underlayer film according to any one of claims 12 to 14, forming an intermediate layer film on the underlayer film by using a silicon atom-containing resist intermediate layer film material, forming at least one photoresist layer on the intermediate layer film, then irradiating a required region of the photoresist layer with radiation, performing alkaline development to form a resist pattern, thereafter etching the intermediate layer film while the resist pattern serves as a mask, etching the underlayer film while the resulting intermediate layer film pattern serves as an etching mask, and etching the substrate while the resulting underlayer film pattern serves as an etching mask to thereby form a pattern on the substrate.

**INTERNATIONAL SEARCH REPORT**

International application No. PCT/JP2013/054763

A. CLASSIFICATION OF SUBJECT MATTER
*C08G10/04*(2006.01)i, *G03F7/11*(2006.01)i

According to International Patent Classification (IPC) or to both national classification and IPC

B. FIELDS SEARCHED

Minimum documentation searched (classification system followed by classification symbols)
C08G8/00-16/06

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | WO 2009/072534 A1 (Mitsubishi Gas Chemical Co., Inc.), 11 June 2009 (11.06.2009), paragraphs [0061], [0062], [0069] & JP 2009-155638 A & US 2011/0009574 A1 & EP 2236530 A1 | 1-17 |
| A | JP 7-173239 A (Mitsubishi Gas Chemical Co., Inc.), 11 July 1995 (11.07.1995), claims 1 to 5 (Family: none) | 1-17 |

☒ Further documents are listed in the continuation of Box C. ☐ See patent family annex.

* Special categories of cited documents:
- "A" document defining the general state of the art which is not considered to be of particular relevance
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| 21 May, 2013 (21.05.13) | 28 May, 2013 (28.05.13) |
| Name and mailing address of the ISA/ Japanese Patent Office | Authorized officer |
| Facsimile No. | Telephone No. |

Form PCT/ISA/210 (second sheet) (July 2009)

**INTERNATIONAL SEARCH REPORT**

International application No.
PCT/JP2013/054763

C (Continuation). DOCUMENTS CONSIDERED TO BE RELEVANT

| Category* | Citation of document, with indication, where appropriate, of the relevant passages | Relevant to claim No. |
|---|---|---|
| A | JP 4-224825 A (Mitsubishi Gas Chemical Co., Inc.), 14 August 1992 (14.08.1992), claim 1; paragraph [0010] (Family: none) | 1-17 |
| A | JP 63-97615 A (Sumitomo Metal Industries, Ltd.), 28 April 1988 (28.04.1988), claims 1 to 6 (Family: none) | 1-17 |
| A | JP 57-165418 A (Mitsubishi Gas Chemical Co., Inc.), 12 October 1982 (12.10.1982), claims 1, 2 (Family: none) | 1-17 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 54086593 A
- JP 2004091550 A
- JP 2009155638 A
- JP 2011046837 A
- JP 2000143937 A
- JP 375747 A
- JP 2002334869 A
- WO 2004066377 A
- JP 2007226170 A
- JP 2007226204 A
- JP 2012039501 A